Europäisches Patentamt

European Patent Office

Office européen des brevets

(11) Publication number: **0 229 322 B1**

# EUROPEAN PATENT SPECIFICATION

(45) Date of publication of patent specification: **26.08.92**    (51) Int. Cl.⁵: **C30B 15/14**

(21) Application number: **86117202.1**

(22) Date of filing: **10.12.86**

(54) **Method and apparatus for Czochralski single crystal growing.**

(30) Priority: **11.12.85 JP 278627/85**

(43) Date of publication of application:
**22.07.87 Bulletin  87/30**

(45) Publication of the grant of the patent:
**26.08.92 Bulletin  92/35**

(84) Designated Contracting States:
**DE FR GB**

(56) References cited:
**DE-A- 2 821 481**
**GB-A- 2 139 918**

**IBM TECHNICAL DISCLOSURE BULLETIN, vol. 28, no. 1, June 1985, pages 211-212, New York, US; "Apparatus for low to medium level oxygen Czochralski silicon crystal growth"**

(73) Proprietor: **SHIN-ETSU HANDOTAI COMPANY, LIMITED**
**4-2, Marunouchi 1-Chome**
**Chiyoda-ku Tokyo(JP)**

(72) Inventor: **Yamagishi, Hirotoshi**
**Shin-sakuragaoka Apartment**
**3-11-20, Isobe, Annaka-shi Gunma-ken(JP)**
Inventor: **Fusegawa, Izumi**
**1290, Koyahara-cho Maebashi-shi**
**Gunma-ken(JP)**
Inventor: **Yokota, Shuji**
**489-4, Machikita-machi Aizuwakamatsu-shi**
**Fukushima-ken(JP)**
Inventor: **Hattori, Junichi**
**285-1, Takanashi Matsuida-cho**
**Usui-gun, Gunma-ken(JP)**
Inventor: **Karasawa, Yukio**
**856, Kenzaki-cho Takasaki-shi**
**Gunma-ken(JP)**
Inventor: **Abe, Takao**
**477-19, Yanase Annaka-shi**
**Gunma-ken(JP)**

(74) Representative: **Jaeger, Klaus, Dr. et al**
**Patentanwälte JAEGER, LORENZ & KÖSTER**
**Pippinplatz 4a**
**W-8035 München-Gauting(DE)**

EP 0 229 322 B1

**Description**

BACKGROUND OF THE INVENTION

The present invention relates to an improvement in a method and apparatus for growing a single crystal of, in particular, semiconductor silicon by the Czochralski method.

As is well known, integrated circuits as a class of electronic devices are manufactured in most cases using a single crystal of high-purity semiconductor silicon as the substrate material. Namely, single crystals of semiconductor silicon grown in the so-called Czochralski method by pulling up from molten silicon on a seed crystal are sliced perpendicularly to the longitudinal axis of the single crystal boule into wafers which are provided after lapping, mirror-polishing and epitaxial surface treatment as the preparatory step for the manufacture of electronic devices such as integrated circuits.

In the conventional Czochralski single crystal growing of semiconductor silicon, the starting polycrystalline silicon material is melted in a quartz glass-made crucible to form a melt from which the single crystal is grown by first dipping the lower end of a seed crystal held on the lower end of a rotating shaft in the melt and then gradually pulling up the shaft upwardly. One of the serious problems in this Czochralski method for the preparation of a single crystal of silicon is that silicon monoxide SiO having vaporizability is produced mainly by the reaction of the molten silicon and the silica crucible at the contacting surface therebetween while the vapor of silicon monoxide is condensed and deposited as solid on the surfaces at lower temperatures such as the water-cooled inner walls of the crystal-growing chamber, surface of the pull-up shaft, upper portion of the inner walls and brim of the crucible and elsewhere and the thus deposited silicon monoxide in the form of tiny particles occasionally falls on to the surface of the molten silicon to greatly disturb the growing condition of the single crystal.

One of the factors influencing the productivity in the Czochralski single crystal growing of semiconductor silicon is the velocity of pulling up which can rarely exceed about 0.5 to 1.0 mm/minute in the industrial production. Along with recent progress in the electronic technology including the trend toward higher and higher density of integration in the integrated circuits, single crystals of semiconductor silicon are required to have a larger and larger diameter while a single crystal of silicon having a large diameter can be grown at a decreased velocity of pulling up in the Czochralski method to increase the costs for production. When the velocity of pulling up is increased to exceed the value appropriate for the diameter of the single crystal to be grown, a disadvantage is caused that the cross section of the single crystal as grown is no longer in a true circular form and such a deformed single crystal boule of non-circular cross section can be worked with great decrease of workability in the subsequent procedures of slicing, lapping, polishing and so on to give no acceptable substrates to be provided for the manufacture of semiconductor devices. One of the reasons for this disadvantage is presumably the increased loss of heat by radiation from the surface of the melt when the velocity of pulling up is unduly increased.

SUMMARY OF THE INVENTION

An object of the present invention is therefore to provide a novel and improved Czochralski method for single crystal growing of semiconductor silicon in which deposition of vaporized silicon monoxide on various surfaces can be efficiently prevented or, even when deposition of silicon monoxide takes place, particles of the deposited silicon monoxide never fall on to the surface of the molten silicon.

Another object of the invention is to provide an improved apparatus for the Czochralski single crystal growing of semiconductor silicon in which a single crystal of semiconductor silicon can be grown without the problems due to the deposition of silicon monoxide on various surfaces or falling of the deposited silicon monoxide, if any, on to the surface of the molten silicon.

The first object given above is solved by the process of the present invention for for growing a single crystal of semiconductor material according to the Czochralski method by dipping the lower end of a seed crystal of semiconductor material held on the lower end of a rotating shaft in the molten semiconductor material contained in a crucible which is located in a crystal-growing chamber and pulling up the seed crystal so as to grow a semiconductor single crystal from the molten semiconductor material on the seed crystal, said process being characterized in that the single crystal under growing is coaxially surrounded with a conically tapered tube hanging down from the center top of the crystal-growing chamber in such a position that the diameter thereof is decreased from the upper end to the lower end and having a heat-insulating refractory multi-layered structure, the innermost layer of which is made of a material having a high thermal conductivity, that the lower end of the conically tapered tube is kept at a height close to the surface of the molten semiconductor material, and that the protecting gas entering from the gas inlet located in the upper part of the chamber flows inside said conically tapered tube in a laminar flow around the growing single crystal.

The second object given above is solved by the apparatus of the invention for growing a single crystal of semiconductor material by the CZOCHRALSKI method comprising a crucible for containing a melt of semi-conductor material and being located in a crystal-growing chamber comprising a gas inlet and a gas outlet, a means to rotate the crucible, a rotatable vertical shaft to hold a seed crystal of semiconductor material on the lower end thereof, and a means to control the height of the crucible, said apparatus being characterized in that a conically tapered tube hangs down from the center top of the crystal-growing chamber, is coaxially held relative to the shaft in such a position that the diameter thereof is decreased from the upper end to the lower end, and has a heat-insulating refractory multi-layered structure, the innermost layer of which has a high thermal conductivity, and that the gas inlet is located in the upper part of the chamber so that the gas flows inside said conically tapered tube.

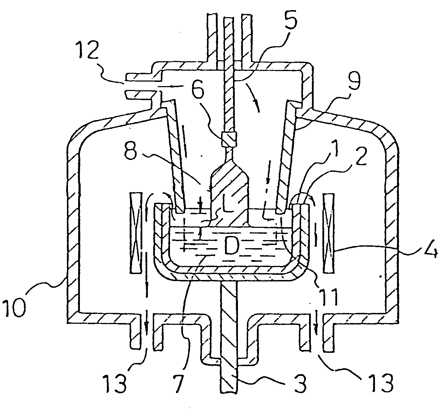

## BRIEF DESCRIPTION OF THE DRAWING

The figure illustrates a vertical cross section of the inventive apparatus taken along the center axis.

## DETAILED DESCRIPTION OF THE PREFERRED EMBODIMENTS

In the following, the method and apparatus improved according to the invention are described in more detail with reference to the accompanying drawing.

As is shown in the figure illustrating a vertical cross section of the apparatus taken along the axis, the quartz glass-made crucible 1 is embedded in and held by the graphite-made crucible holder 2 which can be rotated around the axis and moved up and down by means of the shaft 3. To start the crystal growing process, lumps of polycrystalline silicon are put into the crucible 1 and heated and melted to form a melt of silicon 7 therein by means of the heater 4. The pull-up shaft 5 holds a seed crystal 6 on the lower end thereof. The lower end of the seed crystal 6 is dipped in the melt of silicon 7 kept at a temperature slightly higher than the melting point of silicon and then gradually pulled up at a controlled rate while the pull-up shaft 5 is rotated so that a single crystal 8 of silicon grows on the seed crystal 6 as it is pulled up. The single crystal 8 of silicon under growing in this manner and also the pull-up shaft 5 are coaxially surrounded by a conically tapered tube 9 which hangs down from the center top of the water-cooled crystal-growing chamber 10 at the larger end of the tube 9 to have the smaller end thereof kept close to the surface of the melt 7. It is usual that a protecting gas such as hydrogen, helium, argon and the like is introduced into the chamber 10 through the gas inlet 12 at the upper part of the chamber 10. The gas flows inside the tapered tube 9 along the flow lines shown by the arrows in the figure. Namely, the gas flows down in the space around the pull-up shaft 5 and the growing single crystal 8 surrounded by the tapered tube 9 to escape from the space through the gap between the lower end 11 of the tapered tube 9 and the surface of the melt 7, then to ascend along the inner walls of the crucible 1, to laterally diffuse inside the chamber 10, to descend along the inner walls of the chamber 10 and finally to be discharged out of the gas outlet 13. The volatile matter such as the vapor of silicon monoxide evaporated from the surface of the melt 7 is carried as it is formed by the protecting gas flowing in the above described manner so that deposition of solid silicon monoxide never takes place on the various surfaces inside the chamber 10. The pressure of the atmosphere inside the chamber 10 is not particularly limitative and may be atmospheric, superatmospheric or lower than atmospheric although it is usual when the subject single crystal is of semiconductor silicon that the pressure is kept slightly higher or slightly lower than the atmospheric pressure by adequately controlling the pressure and flow rate of the protecting gas introduced into the chamber 10.

As is mentioned above, the conically tapered tube 9 hanging in the crystal-growing chamber 10 serves to produce a downward gas flow around the growing single crystal 8 at a downwardly increasing flowing velocity through the space surrounded by the tube 9 having a downwardly decreasing cross sectional area. Accordingly, cooling of the growing single crystal 8 is accelerated by the gas flow in addition to absorption of heat from the growing single crystal 8 by the inner walls of the tapered tube 9 and reflection of the heat radiation on the outer walls of the tapered tube 9. These functions of the tapered tube 9 can better be exhibited when the tube 9 has a multi-layered structure described below.

Namely, the outermost layer of the tapered tube should be formed of a material, preferably, having a low thermal emissivity of, for example, 0.8 or lower and a thermal conductivity as low as possible in order to minimize temperature elevation of the tapered tube. Sintered bodies of silicon nitride $Si_3N_4$ and the like may meet these requirements. Tapered tubes made of a material having a thermal emissivity larger than 0.8 are undesirable in respect of the increase in the temperature even though such a tube may exhibit a higher efficiency as a heat shield.

The material forming the innermost layer of the tapered tube, on the other hand, should preferably be capable of efficiently absorbing the radiant heat with a thermal emissivity of, for example, 0.5 to 1.0 and also should have a coefficient of thermal conductivity as high as possible in order that the tapered tube may serve to conduct the heat upwardly to the top portion of the chamber walls under water-cooling. These requirements can be satisfied by using a material such as carbon, silicon carbide, silicon nitride, boron nitride and the like as well as by using a carbonaceous body coated on the surface with silicon carbide, silicon nitride, boron nitride and the like.

Even when the outermost layer of the tapered tube is made of a material having a high thermal emissivity or high thermal conductivity, quite satisfactory performance of the tube can be ensured by sandwiching a layer, of which the thermal conductivity is low in the direction of thickness but high within the plane of the layer, between the innermost and outermost layers. The thermal conductivity of such a sandwiched layer in the direction of thickness should preferably be 10 kcal/m•hour•°C or smaller. An example of such a material is a mat of carbon fibers. When the thermal conductivity of the sandwiched layer exceeds the above mentioned value, the radiant heat absorbed in the outermost layer is conducted to the innermost layer to increase the surface temperature of the inner walls of the tube so that the efficiency of the tapered tube as a shield against the radiant heat from the growing single crystal is greatly decreased. When the outermost layer is formed of a material having a relatively low thermal conductivity, the thermal flow from the outer surface toward the inner surface is consequently low so that the above mentioned heat-insulating intermediate layer may be omitted. On the other hand, the material forming the innermost layer should desirably have a thermal conductivity as high as possible in order to serve as a heat conductor transferring the heat received from the single crystal under growing to the top portion of the water-cooled chamber walls by thermal conduction. It is also preferable that the material forming the surface layers of the tapered tube is a non-carbonaceous material such as ceramics so that contamination of the growing single crystal by the carbonaceous material can be minimized.

Although carbonaceous materials are quite satisfactory as a material of the tapered tube in respect of the high dimensional accuracy of machining, carbonaceous materials may react with the vapor of silicon monoxide evaporated from the melt of silicon to form carbon monoxide or carbon dioxide which may be a contaminant to cause contamination of the melt and consequently the growing single crystal of silicon with carbon. Sintered ceramic materials, on the other hand, are free from such a problem of contamination with carbon but are disadvantageous in respect of obtaining a sufficiently high dimensional accuracy of the tapered tube shaped thereof. It is a preferable way that the tapered tube is shaped with a carbonaceous material to have a dimensional accuracy as high as desired and then the carbon-made tapered tube is coated with a ceramic material. Table 1 below gives characterization of several materials usable in the tapered tube and the particular layer or layers to be formed of the respective materials.

The lower end 11 of the conically tapered tube 9 should preferably be at such a height as to keep a gap L of from 5 to 30 mm above the surface of the melt 7. As the surface of the melt 7 is lowered in the crucible 1 by the growing of the single crystal 8, the

Table 1

| Material | Layer | Themal conductivity, kcal/m•hour•°C | Thermal emissivity |
|---|---|---|---|
| C | innermost | 120 | ca.0.8 |
| SiC | innermost or outermost | 39 | ca.0.8 |
| BN | ditto | 55.8[a) ] 3.6 [b) ] | ca.0.3 |
| $Si_3N_4$ | ditto | 15 | ca.0.5 |
| Carbon fibers | intermediate | 4 | ca.0.8 |

a) parallel to a-axis;
b) parallel to c-axis

crucible 1 may be elevated by means of the shaft 3 so as to keep the gap L within the above mentioned range. The inner diameter D of the tapered tube 9 at the lower end 11 should preferably be in the range from about 1.2 times of that of the single crystal 8 of silicon to be grown to about 0.8 times of the inner diameter of the quartz crucible 1 at the brim. When the values of L and/or D are not within the above mentioned respective ranges, disadvantages are caused that the temperature gradient or distribution at or in the vicinity of the interface of the growing single crystal cannot be kept adequate so that the rate of single crystal growing may be limited and that deposition of silicon monoxide may take place around the upper brim of the quartz crucible 1 and the deposit may eventually enters the melt 7 of silicon to disturb the growth of the single crystal 8.

In addition to the above described advantages, an additional advantage is obtained in the inventive method and apparatus that a means is provided for the control of the content of oxygen in the single crystal of silicon as grown. Namely, the content of oxygen in the single crystal can be decreased by increasing the flow rate of the downward stream of the protecting gas through the space surrounded by the conically tapered tube or vice versa.

To summarize, the conically tapered tube used in the inventive method and apparatus serves to produce a laminar flow of the protecting gas around the single crystal under growing and the gas flow efficiently sweeps off the vapor of silicon monoxide to prevent silicon monoxide from being deposited on various surfaces so that any disturbance caused by the particles of silicon monoxide entering the melt of silicon can be minimized. Furthermore, the tapered tube serves as a heat shield for the growing single crystal from the heat radiation emitted from the inner walls of the crucible and also serves to accelerate cooling of the growing single crystal by virtue of the increased flow rate of the protecting gas in a laminar flow around the growing single crystal so that the pulling-up velocity of the single crystal can be increased.

Although the subject matters of the invention have been described above mainly with respect to the single crystal growing process of semiconductor silicon, it has to be understood that the inventive method and apparatus are applicable to any Czochralski processes for the preparation of semiconductor single crystals of other kinds such as so-called III-V compound semiconductors and single crystals of any other materials such as oxide single crystals to give advantages of increasing the crystal growing velocity and preventing troubles caused by any deposited matter entering the melt in the crucible.

Example.

A quartz glass-made crucible having a brim diameter of 250 mm was charged with 20 kg of lumps of polycrystalline silicon and growing of a single crystal of silicon having a diameter of 110 mm was performed in a usual way keeping the pressure inside the crystal-growing chamber at 10 mbar with continuous introduction of argon gas at a rate of 30 liters/minute from the gas inlet at the upper part of the chamber. A conically tapered tube was installed inside the chamber as illustrated in the figure of the accompanying drawing. The tapered tube had a diameter of 150 mm at the upper end and 140 mm at the lower end and the lower end was kept 20 mm above the surface of the melt in the crucible at the start and thereafter. The tapered tube had a multi-layered structure composed of an outermost layer made of sintered silicon nitride and an innermost layer made of carbon sandwiching a heat-insulating layer of carbon fibers.

The tapered tube installed as above was very advantageous in preventing the disturbance of single crystal growing caused by the particles of silicon monoxide eventually entering the melt in the crucible. The content of carbon contaminant in the thus grown single crystal of silicon was below the limit of detection, i.e. 0.05 ppma at 80% crystallization to show the efficiency of preventing contamination with carbon. The velocity of single crystal pulling-up could be increased to 1.8 mm/minute on an average from the conventional value of 0.8 mm/minute without using the tapered tube. The content of oxygen in the thus grown single crystal of silicon was lower than in the conventional single crystals of silicon by about 2 ppma.

## Claims

**1.** Apparatus for growing a single crystal of semiconductor material by the CZOCHRALSKI method comprising
a crucible for containing a melt of semiconductor material and being located in a crystal-growing chamber comprising
a gas inlet and a gas outlet,
a means to rotate the crucible,
a rotatable vertical shaft to hold a seed crystal of semiconductor material on the lower end thereof,
and a means to control the height of the crucible,
**characterized** in that
a conically tapered tube hangs down from the center top of the crystal-growing chamber, is coaxially held relative to the shaft in such a position that the diameter thereof is decreased from the upper end to the lower end, and has a heat-insulating refractory multi-layered structure, the innermost layer of which has a high thermal conductivity, and that the gas inlet is located in the upper part of the chamber so that the gas flows inside said conically tapered tube.

2. Apparatus as claimed in claim 1,
   **characterized** in that
   the multi-layered structure is composed of an outermost layer, an innermost layer and an intermediate heat-insulating layer sandwiched therebetween.

3. Apparatus as claimed in claim 2,
   **characterized** in that
   the intermediate heat-insulating layer is made of carbon fibres and has a thermal conductivity coefficient not exceeding 10 kcal/m x hour x ° C in the direction of thickness.

4. Apparatus as claimed in claim 1,
   **characterized** in that
   the conically tapered tube has a surface made of a refractory material selected from the group consisting of silicon nitride, silicon carbide and boron nitride.

5. Process for growing a single crystal of semiconductor material according to the CZOCHRALSKI method by dipping the lower end of a seed crystal of semiconductor material held on the lower end of a rotating shaft in the molten semiconductor material contained in a crucible which is located in a crystal-growing chamber and pulling up the seed crystal so as to grow a semiconductor single crystal from the molten semiconductor material on the seed crystal,
   **characterized** in that
   the single crystal under growing is coaxially surrounded with a conically tapered tube hanging down from the center top of the crystal-growing chamber in such a position that the diameter thereof is decreased from the upper end to the lower end and having a heat-insulating refractory multi-layered structure, the innermost layer of which is made of a material having a high thermal conductivity,
   that the lower end of the conically tapered tube is kept at a height close to the surface of the molten semiconductor material, and
   that the protecting gas entering from the gas inlet located in the upper part of the chamber flows inside said conically tapered tube in a laminar flow around the growing single crystal.

6. Process as claimed in claim 5,
   **characterized** in that
   the lower end of the conically tapered tube is held at a height to form a gap of 5 to 30 mm above the surface of the molten semiconductor material.

**Patentansprüche**

1. Vorrichtung zum Ziehen von Halbleiter-Einkristallen nach dem Czochralski-Verfahren mit
   einem Tiegel zum Aufnehmen einer Schmelze aus Halbleitermaterial, der sich in einer Kristallziehkammer befindet, die
   einen Gaseinlaß und einen Gasauslaß,
   ein Mittel zum Drehen des Tiegels,
   eine drehbare vertikale Welle zum Halten eines Halbleiter-Impfkristalls an deren unterem Ende und einem Mittel zum Einstellen der Höhe des Tiegels aufweist,
   dadurch **gekennzeichnet**,
   daß ein konisch verjüngtes Rohr vom zentralen Oberteil der Kristallziehkammer herunterhängt, koaxial relativ zur Welle in solch einer Position gehalten wird, daß sein Durchmesser vom oberen Ende zum unteren Ende abnimmt, und das eine wärmeisolierende, reflektierende Mehrschichtstruktur, deren innerste Schicht eine hohe thermische Leitfähigkeit aufweist, besitzt, und daß sich der Gaseinlaß im oberen Teil der Kammer befindet, so daß das Gas innerhalb des konisch verjüngten Rohres fließt.

2. Vorrichtung nach Anspruch 1,
   dadurch **gekennzeichnet**,
   daß sich die Mehrschichtstruktur aus einer äußeren Schicht, einer inneren Schicht und einer nach Sandwichbauweise dazwischenliegenden wärmeisolierenden Schicht zusammensetzt.

3. Vorrichtung nach Anspruch 2,
dadurch **gekennzeichnet**,
daß die wärmeisolierende Zwischenschicht aus Kohlenstoffasern gefertigt ist und einen thermischen Leitfähigkeitskoeffizienten besitzt, der 10 kcal/m x h x ° C in Richtung der Dicke nicht übersteigt.

4. Vorrichtung nach Anspruch 1,
dadurch **gekennzeichnet**,
daß das konisch verjüngte Rohr eine Oberfläche aufweist, die aus einem reflektierenden Material besteht, das aus der aus Siliciumnitrid, Siliciumcarbid und Bornitrid bestehenden Gruppe ausgewählt ist.

5. Verfahren zum Ziehen eines Halbleiter-Einkristalls nach dem Czochralski-Verfahren, in dem das untere Ende eines Halbleiter-Impfkristalls, der am unteren Ende einer sich drehenden Welle gehalten wird, in die in einem Tiegel enthaltene Halbleiterschmelze, der sich in einer Kristallziehkammer befindet, getaucht wird und der Impfkristall so hochgezogen wird, daß ein Halbleiter-Einkristall aus der Halbleiterschmelze am Impfkristall gezogen wird,
dadurch **gekennzeichnet**,
daß der Einkristall beim Ziehen koaxial von einem konisch verjüngten Rohr umgeben ist, das vom zentralen Oberteil der Kristallziehkammer in solch einer Position herunterhängt, daß dessen Durchmesser vom oberen Ende zum unteren Ende abnimmt und das eine wärmeisolierende, reflektierende Mehrschichtstruktur besitzt, deren innere Schicht aus einem Material mit hoher thermischer Leitfähigkeit besteht,
daß das untere Ende des konisch verjüngten Rohres in einer Höhe nahe der Oberfläche der Halbleiterschmelze gehalten wird, und
daß das Schutzgas, das durch den Gaseinlaß im oberen Teil der Kammer eintritt, innerhalb des konisch verjüngten Rohres in einer laminaren Strömung um den wachsenden Einkristall herum fließt.

6. Verfahren nach Anspruch 5,
dadurch **gekennzeichnet**,
daß das untere Ende des konisch verjüngten Rohres in einer solchen Höhe gehalten wird, daß ein Zwischenraum von 5 bis 30 mm über der Oberfläche der Halbleiterschmelze gebildet wird.

**Revendications**

1. Appareil pour la croissance d'un mono-cristal de matériau semi-conducteur selon la méthode Czochralski comprenant un creuset devant contenir un bain de matériau semi-conducteur fondu et étant placé dans une chambre de croissance de cristaux comportant une admission de gaz et une évacuation de gaz, des moyens pour faire tourner le creuset, un arbre vertical rotatif pour maintenir un germe de cristal du matériau semi-conducteur sur l'extrémité inférieure de celui-ci et des moyens pour commander la hauteur du creuset,
caractérisé en ce que
un tube effilé coniquement est suspendu vers le bas à partir du sommet central de la chambre de croissance de cristaux, est maintenu coaxialement par rapport à l'arbre dans une position telle que son diamètre décroisse de l'extrémité supérieure vers l'extrémité inférieure, et comporte une structure multi-couches réfractaire, thermoisolante, dont la couche intérieure présente une conductivité thermique élevée, et en ce que l'orifice d'admission de gaz est situé dans la partie supérieure de la chambre de manière que le gaz circule à l'intérieur dudit tube effilé coniquement.

2. Appareil selon la revendication 1, caractérisé en ce que la structure multi-couches est composée d'une couche extérieure, d'une couche intérieure et d'une couche intermédiaire thermo-isolante placée en sandwich entre elles.

3. Appareil selon la revendication 2, caractérisé en ce que la couche intermédiaire thermo-isolante est faite de fibres de carbone et elle présente un coefficient de conductivité thermique ne dépassant pas 10 kcal/m x heure x ° C, dans le sens de l'épaisseur.

4. Appareil selon la revendication 1, caractérisé en ce que le tube effilé coniquement présente une surface constituée d'un matériau réfractaire choisi dans le groupe comprenant le nitruree de silicium, le carbure de silicium et le nitrure de bore.

**5.** Procédé de croissance d'un mono-cristal de matériau semi-conducteur selon la méthode Czochralski qui consiste à plonger l'extrémité inférieure d'un germe de cristal de matériau semi-conducteur, maintenu sur l'extrémité inférieure d'un arbre rotatif, dans le matériau semi-conducteur fondu contenu dans un creuset qui est placé dans une chambre de croissance de cristaux et à étirer le germe de cristal de manière à faire croître un mono-cristal semi-conducteur à partir du matériau semi-conducteur fondu sur le germe de cristal,
caractérisé en ce que,
le mono-cristal en cours de croissance est entouré coaxialement par un tube effilé coniquement suspendu vers le bas à partir du sommet central de la chambre de croissance des cristaux dans une position telle que son diamètre décroît à partir de l'extrémité supérieure vers l'extrémité inférieure et présentant une structure multi-couches réfractaire, thermo-isolante, dont la couche intérieure est faite d'un matériau ayant une conductivité thermique élevée,
en ce que l'extrémité inférieure du tube effilé coniquement est maintenue à une hauteur proche de la surface du matériau semi-conducteur fondu et en ce que le gaz protecteur pénétrant à partir de l'orifice d'admission situé dans la partie supérieure de la chambre, s'écoule dans ledit tube effilé coniquement, selon un écoulement laminaire autour du mono-cristal en cours de croissance.

**6.** Procédé selon la revendication 5, caractérisé en ce que l'extrémité inférieure du tube effilé coniquement est maintenue à une hauteur de façon à former un intervalle de 5 à 30 mm au-dessus de la surface du matériau semi-conducteur fondu.